# EUROPÄISCHE PATENTSCHRIFT

(11) **EP 0 678 977 B1**
(45) Veröffentlichungstag und Bekanntmachung des Hinweises auf die Patenterteilung: **11.11.1998**
(21) Anmeldenummer: 95105051.7
(22) Anmeldetag: 04.04.1995
(51) Int. Cl.: H03H 9/02, H03H 9/64

(54) **Mit akustischen Oberflächenwellen arbeitendes Filter**
Filter operating with surface acoustic waves
Filtre fonctionnant avec des ondes acoustiques de surface

(30) Priorität: 22.04.1994 DE 4414160
(43) Veröffentlichungstag der Anmeldung: 25.10.1995
(73) Patentinhaber: SIEMENS MATSUSHITA COMPONENTS GmbH & CO. KG, 81617 München (DE)
(72) Erfinder: Bauregger, Josef, Dipl.-Ing., D-81737 München (DE)
(74) Vertreter: Epping, Wilhelm, Dr.-Ing.

(56) Entgegenhaltungen:
- PATENT ABSTRACTS OF JAPAN vol. 15 no. 157 (E-1058) ,19.April 1991 & JP-A-03 029407 (MITSUBISHI) 7.Februar 1991,

## Beschreibung

Die vorliegende Erfindung betrifft ein mit akustischen Oberflächenwellen arbeitendes Filter - OFW-Filter - nach dem Oberbegriff des Patentanspruchs 1.

In der Patentanmeldung WO-A-94/21040, welche Stand der Technik gemäß Art.54(3), EPÜ, darstellt, ist ausgeführt, daß OFW-Filter, insbesondere Filter mit feinen Strukturen empfindlich gegen elektrostatische Entladungen sind und bei Berührung mit elektrostatisch geladenen Teilen durch Entladung dieser Teile über einen im Filter enthaltenen Interdigitalwandler zerstört werden können.

In der genannten Veröffentlichung wird vorgeschlagen, in einem Digitalwandler eines OFW-Bauelementes zum Schutz gegen elektrostatische Entladung durch Berührung mit elektrostatisch geladenen Teilen einen mäanderförmigen elektrischen Widerstand parallel zu schalten, dessen Wert derart festgelegt ist, daß die Zeitkonstante aus einem Innenwiderstand und einer Eigenkapazitat der durch ein elektrostatisch geladenes Teil gebildeten Spannungsquelle groß gegen die Zeitkonstante aus Parallelwiderstand und Eigenkapazität des Interdigitalwandlers ist, der Parallelwiderstand wird dabei zweckmaßigerweise auf dem Substrat des Filters als mäanderförmige integrierte Widerstandsschicht ausgebildet.

Eine ähnliche Anordnung ist aus JP-A-3-029407 (7.2.91) bekannt, in welcher zum Schutz gegen elektrostatische Zerstörung und zur Anpassung eine Widerstands- bzw. Induktivitätsstruktur an die beiden Sammelschienen des Interdigitalwandlers angeschlossen ist.

Bei einer derartigen Schutzmaßnahme tritt jedoch noch das Problem auf, daß zur Realisierung des Schutzwiderstandes neben den Komponenten des OFW-Bauelementes eine relativ lange Metallstruktur erforderlich ist.

Der vorliegenden Erfindung liegt die Aufgabe zugrunde, OFW-Filter der in Rede stehenden Art so weiterzubilden, daß die Schutzmaßnahme platzsparend realisiert ist.

Diese Aufgabe wird bei einem OFW-Filter der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird im folgenden anhand von in den Figuren der Zeichnung dargestellten Ausführungsbeispielen näher erläutert. Es zeigt:
- Figur 1: eine schematische Darstellung eines OFW-Resonators mit einem erfindungsgemäß ausgebildeten Schutzwiderstand; und
- Figur 2: eine der Figur 1 entsprechende Darstellung mit einer verbesserten mäanderförmigen Ausbildung eines Schutzwiderstandes.

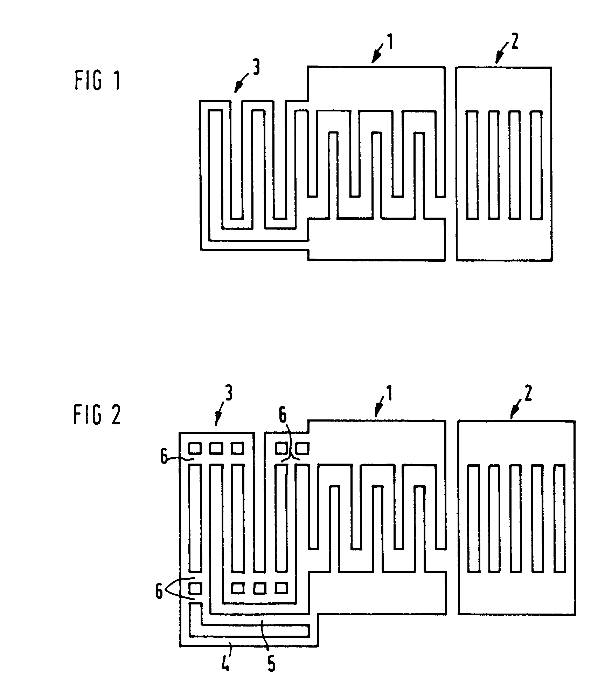

Figur 1 zeigt in schematischer Darstellung den Aufbau eines OFW-Resonators mit einem Interdigitalwandler 1 und einem Reflektor 2 auf einer Seite dieses Interdigitalwandlers 1. Bei einem üblichen OFW-Resonator ist auf der dem Reflektor 2 abgewandten Seite des Interdigitalwandlers 1 ebenfalls ein dem Reflektor 2 ebenfalls ein entsprechender Reflektor angeordnet.

Erfindungsgemäß ist in diesen oder in beiden Reflektoren jedoch ein elektrischer Widerstand 3 integriert, der elektrisch mit dem Interdigitalwandler 1 verbunden ist. Dieser mäanderförmige elektrische Widerstand 3 wirkt also gleichzeitig als Reflektor für akustische Oberflächenwellen, wodurch eine platzsparende Ausbildung von Reflektor und Widerstand realisiert ist. Die Schutzwirkung dieses Widerstandes 3 gegen elektrostatische Entladung etwa durch Berührung mit elektrostatisch geladenen Teilen, entspricht der Wirkung, wie sie bereits in obengenannten Dokumenten WO-A-94/21040 bzw. JP-A-3-029407 beschrieben ist.

Bei der Ausführungsform nach Figur 2, in der gleiche Teile wie in Figur 1 mit gleichen Bezugszeichen versehen sind, wird der Widerstand durch zwei elektrisch parallel geschaltete Mäander 4, 5 gebildet, wobei die Parallelschaltung durch Querstege 6 zustande kommt. Dies besitzt den Vorteil, daß bei mechanischer Unterbrechung einer der Mäanderlinien 4, 5, beider Mäanderlinien oder von Querstegen 6 noch soviel leitende Verbindungen erhalten bleiben, daß die elektrische Widerstandswirkung praktisch unverändert erhalten bleibt.

## Patentansprüche

1. Mit akustischen Oberflächenwellen arbeitendes Filter - OFW-Filter - mit mindestens einem durch Interdigitalwandler (1) und Reflektoren (2, 3) gebildeten Resonator (1, 2, 3), bei dem mindestens einer Filterkomponente zum Schutz gegen elektrostatische Entladung durch Berührung mit elektrostatisch geladenen Teilen ein elektrischer Widerstand parallel geschaltet ist,
**dadurch gekennzeichnet,** daß der elektrische Widerstand in einen Reflektor (3) oder in beiden Reflektoren (3 und 2) des Resonators (1, 2, 3) integriert ist.

2. OFW-Filter nach Anspruch 1,
**dadurch gekennzeichnet,** daß der elektrische Widerstand (3) durch zwei odere mehrere parallel geschaltete Mäander (4, 5) gebildet ist.

3. OFW-Filter nach Anspruch 1 und 2,
**dadurch gekennzeichnet,** daß die Mäander (4, 5) durch Querstege (6) parallel geschaltet sind.

## Revendications

1. Filtre travaillant avec des ondes acoustiques de surface - filtre OS - comprenant au moins un résonateur (1, 2, 3) formé d'un convertisseur interdigital (1) et de réflecteurs (2, 3), dans lequel une résistance électrique est connectée en parallèle à au moins un composant du filtre pour la protection à l'encontre de la décharge électrostatique résultant d'un contact avec des éléments chargés d'électricité statique,
caractérisé en ce que la résistance électrique est intégrée dans un réflecteur (3) ou dans les deux réflecteurs (3 et 2) du résonateur (1, 2, 3).

2. Filtre OS selon la revendication 1,
caractérisé en ce que la résistance électrique (3) est formée de deux ou plus de deux méandres (4, 5) connectés en parallèle.

3. Filtre OS selon les revendications 1 et 2,
caractérisé en ce que les méandres (4, 5) sont connectés en parallèle par des isthmes transversaux (6).

## Claims

1. Filter operating with surface acoustic waves - SAW filter - having at least one resonator (1, 2, 3) formed by an interdigital converter (1) and reflectors (2, 3), in which an electrical resistor is connected in parallel with at least one filter component in order to protect against electrostatic discharge due to contact with electrostatically charged particles, characterized in that the electrical resistor is integrated in one reflector (3) or in both reflectors (3 and 2) of the resonator (1, 2, 3).

2. SAW filter according to Claim 1, characterized in that the electrical resistor (3) is formed by two or more meanders (4, 5) connected in parallel.

3. SAW filter according to Claim 1 and 2, characterized in that the meanders (4, 5) are connected in parallel by transverse bridges (6).
